# FASCICULE DE BREVET EUROPEEN

(11) **EP 4 088 312 B1**
(45) Date de publication et mention de la délivrance du brevet: **13.03.2024**
(21) Numéro de dépôt: 21704847.9
(22) Date de dépôt: 07.01.2021
(51) Int. Cl.: H01L 21/324, H01L 21/225, H01L 21/762, H01L 21/02, H01L 21/761

(54) **PROCÉDÉ DE FABRICATION D'UNE STRUCTURE DE TYPE SEMI-CONDUCTEUR SUR ISOLANT POUR APPLICATIONS RADIOFRÉQUENCES**
VERFAHREN ZUR HERSTELLUNG EINER HALBLEITER-AUF-ISOLATOR-STRUKTUR FÜR HOCHFREQUENZANWENDUNGEN
METHOD FOR MANUFACTURING A SEMICONDUCTOR-ON-INSULATOR STRUCTURE FOR RADIOFREQUENCY APPLICATIONS

(30) Priorité: 07.01.2020 FR 2000098
(43) Date de publication de la demande: 16.11.2022
(73) Titulaire: SOITEC, 38190 Bernin (FR)
(72) Inventeur: GHORBEL, Aymen, 38190 BERNIN (FR); ALLIBERT, Frédéric, 38190 BERNIN (FR); MASSY, Damien, 38190 BERNIN (FR); BERTRAND, Isabelle, 38190 BERNIN (FR); NOURI, Lamia, 38190 BERNIN (FR)
(74) Mandataire: Regimbeau
(86) Numéro de dépôt international: PCT/FR2021/050018
(87) Numéro de publication internationale: WO 2021/140300

(56) Documents cités:
- US-A1- 2012 235 283
- BARAKEL D ET AL: "n-p Junction formation in p-type silicon by hydrogen ion implantation", SOLAR ENERGY MATERIALS AND SOLAR CELLS, ELSEVIER SCIENCE PUBLISHERS, AMSTERDAM, NL, vol. 72, no. 1-4, 1 avril 2002 (2002-04-01), pages 285-290, XP004339776, ISSN: 0927-0248, DOI: 10.1016/S0927-0248(01)00176-3
- RACK M ET AL: "Low-Loss Si-Substrates Enhanced Using Buried PN Junctions for RF Applications", IEEE ELECTRON DEVICE LETTERS, IEEE, USA, vol. 40, no. 5, 1 mai 2019 (2019-05-01), pages 690-693, XP011721119, ISSN: 0741-3106, DOI: 10.1109/LED.2019.2908259 [extrait le 2019-04-24]

## Description

### DOMAINE TECHNIQUE DE L'INVENTION

La présente invention concerne un procédé de fabrication d'une structure de type semi-conducteur sur isolant, notamment pour des applications radiofréquences.

### ETAT DE LA TECHNIQUE

Les structures de type semi-conducteur sur isolant sont des structures multicouches comprenant un substrat qui est généralement en silicium, une couche électriquement isolante agencée sur le substrat, qui est généralement une couche d'oxyde telle qu'une couche d'oxyde de silicium, et une couche semi-conductrice agencée sur la couche isolante, qui est généralement une couche de silicium.

De telles structures sont dites structures « Semiconductor on Insulator » (acronyme SeOI) en anglais, en particulier « Silicon on Insulator » (SOI) lorsque le matériau semi-conducteur est du silicium.

Parmi les structures SOI existantes, les structures dites « Fully-Depleted Silicon on Insulator» en anglais (acronyme FD-SOI) sont couramment utilisées pour des applications digitales. Les structures FD-SOI se caractérisent par la présence d'une couche mince d'oxyde, agencée sur un substrat support en silicium, et d'une couche semi-conductrice très mince agencée sur la couche d'oxyde, dite couche SOI.

La couche d'oxyde se trouve entre le substrat et la couche SOI. La couche d'oxyde est alors dite « enterrée », et est appelée « BOX » pour « Buried OXide » en anglais.

La couche SOI permet d'implémenter le canal de conduction de la structure FD-SOI.

Du fait de la faible épaisseur et de l'uniformité de la couche de BOX et de la couche SOI, il n'est pas nécessaire de doper le canal de conduction, d'où le fait que la structure puisse fonctionner selon un mode totalement déplété.

Les structures FD-SOI présentent des caractéristiques électrostatiques améliorées par rapport aux structures sans couche de BOX. La couche de BOX diminue la capacité électrique parasite entre la source et le drain, et permet également de réduire considérablement les fuites d'électrons depuis le canal de conduction vers le substrat en confinant le flux d'électrons dans le canal de conduction, réduisant ainsi les pertes de courant électrique et améliorant les performances de la structure.

Les structures FD-SOI peuvent être compatibles avec des applications radiofréquences (RF), mais pâtissent cependant de l'apparition de pertes électriques dans ledit substrat.

Pour pallier ces pertes électriques et améliorer les performances RF, il est connu d'utiliser un substrat, notamment de type SOI, présentant une haute résistivité électrique, ce type de substrat étant communément appelé « substrat HR » pour substrat à haute résistivité. Ce dernier est avantageusement combiné avec une couche de piégeage de charges (« trap-rich layer » en anglais).

Cependant, ce type de substrat n'est pas compatible avec une utilisation de transistors dont la tension de seuil doit être contrôlée par une grille en face arrière (« back bias voltage » en anglais »). En effet, la présence de cette couche comportant des charges piégées gêne la polarisation en face arrière (application d'une différence de potentiel au niveau de la face arrière).

La publication scientifique "Low loss Si-substrates enhanced using buried PN junctions for RF applications" (M. Rack, L. Nyssens, and J-P. Raskin, IEEE Electron device letters, vol. 40, Issue 5) décrit la formation de jonctions P-N agencées latéralement sous la couche électriquement isolante d'un substrat destiné à des applications radiofréquences.

Par latéralement, on entend que deux régions respectivement dopées P et N sont agencées à une même profondeur du substrat, la jonction entre lesdites régions étant sensiblement perpendiculaire à la surface principale du substrat. Une telle jonction est obtenue par implantation de phosphore sur l'ensemble du substrat pour un dopage de type N suivie d'une implantation localisée de bore au travers d'un masque pour former des régions dopées P, puis d'un traitement thermique d'activation des dopants.

Alors qu'un semi-conducteur dopé est un bon conducteur, la jonction ne laisse quasiment pas passer le courant électrique, empêchant ainsi la propagation de champs électriques parasites.

Un inconvénient résultant d'un agencement latéral de la jonction P-N comme décrit dans la publication scientifique est qu'il nécessite une étape de lithographie pour la formation du masque et deux étapes d'implantation, ce qui représente un surcoût important.

Le document US 2012/235283 concerne un procédé de fabrication d'une jonction P-N à partir d'un substrat de type FD-SOI comprenant un substrat semi-conducteur monocristallin présentant une teneur en oxygène interstitiel comprise entre 3 et 18 old ppma.

L'article de D. Barakel et al, « n-p Junction formation in p-type silicon by hydrogen ion implantation », Solar Energy Materials & Solar Cells 72 (2002) 285-290 porte sur la mise en oeuvre d'une implantation ionique d'hydrogène dans un substrat de silicium dopé P pour y former une jonction P-N.

### BREVE DESCRIPTION DE L'INVENTION

Un but de l'invention est de proposer un procédé de fabrication d'une structure de type semi-conducteur sur isolant permettant de surmonter les inconvénients mentionnés précédemment.

L'invention vise à proposer un tel procédé de fabrication permettant de fabriquer une structure de type FD-SOI présentant de bonnes performances radiofréquences.

A cette fin, l'invention propose un procédé de fabrication d'une structure de type semi-conducteur sur isolant, comprenant les étapes suivantes :
- fourniture d'un substrat de type FD-SOI comprenant successivement, depuis sa base vers son sommet :
   - un substrat semi-conducteur monocristallin présentant une résistivité électrique comprise entre 500 Ω.cm et 30 kΩ.cm, une teneur en oxygène interstitiel comprise entre 20 et 40 old ppma, et présentant un dopage de type P ou N,
   - une couche électriquement isolante présentant une épaisseur comprise entre 20 nm et 400 nm,
   - une couche semi-conductrice monocristalline présentant un dopage de type P,
- traitement thermique du substrat de type FD-SOI à une température supérieure ou égale à 1175°C pendant un temps supérieur ou égal à 1h, afin de former une jonction P-N dans le substrat semi-conducteur monocristallin à une profondeur déterminée par rapport à la couche électriquement isolante,
   - par la diffusion de dopants de type P depuis la couche semi-conductrice monocristalline au travers de la couche électriquement isolante dans ledit substrat,
   - et, si le substrat est dopé de type P, par la formation dans ledit substrat de donneurs thermiques par précipitation de l'oxygène interstitiel, et
pour former, dans le substrat, une première région dopée de type N s'étendant entre la base du substrat et la jonction P-N et une deuxième région dopée de type P située entre la première région et la couche électriquement isolante.

La principale technique de mesure de l'oxygène interstitiel dans le silicium d'un substrat semi-conducteur est l'absorption infrarouge par spectrométrie infrarouge à transformée de Fourier (acronyme FTIR des termes anglo-saxons Fourier Transform InfraRed spectrometry).

Cette mesure FTIR fournit une valeur d'un coefficient d'absorption α_{OX} dû à l'oxygène interstitiel. La concentration en oxygène interstitiel est calculée à partir de ce coefficient d'absorption α_{OX}, selon la méthode décrite notamment dans le document, « A Study of Oxygen Précipitation in Heavily Doped Silicon » (1989), Graupner, Robert Kurt, Dissertations and Theses, Paper 1218.

Selon cette méthode, la concentration en oxygène en atome par cm³ (at/cm³) ou en tant que fraction de la quantité totale d'atomes présents en partie pour million (ppma) est obtenue en multipliant le coefficient d'absorption α_{OX} par un facteur de conversion.

La concentration en oxygène dont il est question dans l'invention (old ppma) est obtenue en utilisant le premier des quatre facteurs de conversion présentés dans la liste suivante, dit « old ASTM » (acronyme des termes anglo-saxons « American Society for Testing »), exprimé en ppma :

| | |
|---|---|
| UId ASTM (ASTM F121-79) | ppma = 9.63α_{OX} |
| | atoms/cm³ = 4.81 × 10¹⁷α_{OX} |
| New ASTM (ASTM F121-83) | ppma = 4.9α_{OX} |
| | atoms/cm³ = 2.45 × 10¹⁷α_{OX} |
| JEIDA | ppma = 6.1α_{OX} |
| | atoms/cm³ = 3.03 × 10¹⁷α_{OX} |
| IOC-88 | ppma = 6.28α_{OX} |
| | atoms/cm³ = 3.14 × 10¹⁷α_{OX} |

Selon d'autres aspects, le procédé de fabrication de l'invention présente les différentes caractéristiques suivantes prises seules ou selon leurs combinaisons techniquement possibles :
- le substrat monocristallin est en silicium et/ou la couche monocristalline est une couche de silicium ;
- le substrat de type FD-SOI est obtenu par transfert d'une couche d'un substrat donneur sur un substrat receveur, selon les étapes suivantes :
   - fourniture
      - du substrat donneur comprenant une couche semi-conductrice monocristalline présentant un dopage de type P, et une zone de fragilisation située dans la couche de silicium monocristallin délimitant la couche à transférer, et
      - du substrat receveur semi-conducteur monocristallin, présentant une résistivité électrique comprise entre 500 Ω.cm et 30 kΩ.cm, une teneur en oxygène interstitiel comprise entre 20 et 40 old ppma, et un dopage de type P ou N,
   - collage du substrat donneur sur le substrat receveur par l'intermédiaire d'une couche électriquement isolante présentant une épaisseur comprise entre 20 nm et 400 nm,
   - détachement du substrat donneur le long de la zone de fragilisation, pour former le substrat de type FD-SOI ;
- le substrat de type FD-SOI est obtenu par transfert d'une couche d'un substrat donneur sur un substrat receveur, selon les étapes suivantes :
   - fourniture
      - du substrat donneur comprenant une couche semi-conductrice monocristalline présentant un dopage de type P, et
      - du substrat receveur semi-conducteur monocristallin, présentant une résistivité électrique comprise entre 500 Ω.cm et 30 kΩ.cm, une teneur en oxygène interstitiel comprise entre 20 et 40 old ppma, et un dopage de type P ou N,
   - collage du substrat donneur sur le substrat receveur par l'intermédiaire d'une couche électriquement isolante présentant une épaisseur comprise entre 20 et 400nm,
   - amincissement du substrat donneur depuis la surface opposée au substrat receveur pour former la couche transférée, afin d'obtenir le substrat de type FD-SOI ;
- la zone de fragilisation est formée par implantation d'espèces atomiques dans le substrat donneur, afin de délimiter la couche à transférer ;
- le substrat receveur et la couche monocristalline du substrat donneur sont dopés P avec du bore ;
- la jonction P-N est formée à une profondeur comprise entre 1 µm et 5 µm à partir de la couche électriquement isolante ;
- la couche électriquement isolante comprend une couche d'oxyde de silicium.

Un autre aspect, qui ne fait pas l'objet des revendications, concerne une structure de type semi-conducteur sur isolant obtenue directement par la mise en oeuvre du procédé de fabrication décrit précédemment, ladite structure de type semi-conducteur sur isolant comprenant successivement, depuis sa base vers son sommet :
- un substrat semi-conducteur monocristallin présentant une résistivité électrique comprise entre 500 Ω.cm et 30 kΩ.cm, une teneur en oxygène interstitiel comprise entre 20 et 40 old ppma, et comprenant :
   - une première région comprenant un dopage de type N,
   - une deuxième région agencée sur la première région, comprenant un dopage de type P, la deuxième région étant séparée de la première région par une jonction P-N,
- une couche électriquement isolante,
- une couche semi-conductrice monocristalline comprenant un dopage de type P.

Selon d'autres aspects, ladite structure présente les différentes caractéristiques suivantes prises seules ou selon leurs combinaisons techniquement possibles :
- la couche semi-conductrice monocristalline est dopée P avec du bore ;
- la jonction P-N est située à une profondeur comprise entre 1 µm et 5 µm à partir de la couche électriquement isolante ;
- la couche électriquement isolante comprend une couche d'oxyde de silicium ;
- le substrat monocristallin est en silicium et/ou la couche monocristalline est une couche de silicium.

### DESCRIPTION DES FIGURES

D'autres avantages et caractéristiques de l'invention apparaîtront à la lecture de la description suivante donnée à titre d'exemple illustratif et non limitatif, en référence aux figures annexées suivantes :
- la figure 1 est un schéma d'un substrat de type FD-SOI ;
- la figure 2 est un schéma d'une structure de type semi-conducteur sur isolant comprenant une jonction P-N, conformément à l'invention ;
- la figure 3 est un schéma qui illustre l'inversion du dopage d'une portion du substrat monocristallin à haute résistivité électrique ;
- la figure 4 est un schéma qui illustre la diffusion du dopant de la couche monocristalline au travers de la couche électriquement isolante sous-jacente ;
- la figure 5A est un schéma qui illustre la formation d'une zone de fragilisation par implantation d'espèces atomiques dans un substrat donneur, selon un premier mode de réalisation ;
- la figure 5B est un schéma qui illustre le collage du substrat donneur sur un substrat receveur selon le premier mode de réalisation ;
- la figure 5C est un schéma qui illustre le décollement du substrat donneur le long de la zone de fragilisation, et le transfert d'une couche depuis le substrat donneur sur le substrat receveur, selon le premier mode de réalisation ;
- la figure 6A est un schéma qui illustre le collage du substrat donneur sur un substrat receveur selon un deuxième mode de réalisation ;
- la figure 6B est un schéma qui illustre l'amincissement du substrat donneur depuis la surface opposée au substrat receveur pour former la couche transférée ;
- la figure 7 est un graphe qui illustre le gain HD2 pour une structure de type semi-conducteur sur isolant avec ou sans jonction P-N dans le substrat à haute résistivité électrique,
- la figure 8 est un graphe qui illustre le gain S21 pour une structure de type semi-conducteur sur isolant avec ou sans jonction P-N dans le substrat à haute résistivité électrique ;
- la figure 9 est un graphe qui illustre la résistivité d'une structure de type semi-conducteur sur isolant avec ou sans jonction P-N dans le substrat à haute résistivité électrique.

### DESCRIPTION DETAILLEE DE MODES DE REALISATION DE L'INVENTION

L'invention concerne un procédé de fabrication d'une structure de type semi-conducteur sur isolant, ainsi qu'une telle structure.

Le procédé de fabrication de l'invention permet de fabriquer des structures de type semi-conducteur sur isolant comprenant une jonction P-N conférant à ladite structure de bonnes propriétés radiofréquences, et ce de manière simple et peu coûteuse.

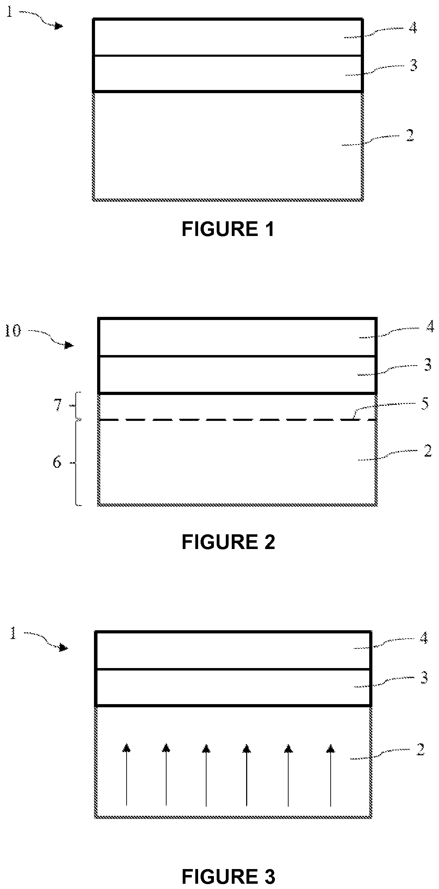

On fournit initialement un substrat de type FD-SOI, représenté schématiquement sur la figure 1 sous la référence 1, qui comprend successivement, depuis sa base vers son sommet, un substrat semi-conducteur monocristallin 2, une couche électriquement isolante 3, et une couche semi-conductrice monocristalline 4.

Le substrat monocristallin 2 est un substrat à haute résistivité électrique, et présente ainsi une résistivité électrique comprise entre 500 Ω.cm et 30 kΩ.cm.

De plus, le substrat monocristallin 2 est un substrat présentant une quantité élevée en oxygène, et présente ainsi une teneur en oxygène interstitiel (Oi) comprise entre 20 et 40 old ppma. L'oxygène est emprisonné dans la structure du substrat monocristallin, plus précisément dans les interstices situés entre les grains du matériau constitutif du substrat monocristallin, et est donc appelé « oxygène interstitiel ».

Le substrat monocristallin à haute résistivité électrique et quantité élevée en oxygène interstitiel est également désigné en tant que substrat HR HiOi (réunion des acronymes des termes anglo-saxons « High Resistivity » et « High Oxygen »).

De préférence, le substrat monocristallin est en silicium.

Le substrat monocristallin présente un dopage de type P ou N.

Dans le cas d'un dopage de type N, le substrat monocristallin 2 est de préférence dopé par du phosphore, et de manière davantage préférée, le substrat monocristallin est en silicium dopé par du phosphore.

Dans le cas d'un dopage de type P, le substrat monocristallin 2 est de préférence dopé par du bore, et de manière davantage préférée, le substrat monocristallin est en silicium dopé par du bore.

La couche électriquement isolante 3, également désignée en tant que couche BOX, en ce qu'elle est agencée entre le substrat monocristallin 2 sous-jacent et la couche monocristalline 4 sus-jacente, présente une épaisseur comprise entre 20 nm et 400 nm.

De préférence, la couche électriquement isolante 3 comprend une couche d'oxyde de silicium.

La couche monocristalline 3 présente un dopage de type P.

De préférence, la couche monocristalline est une couche de silicium.

Selon le procédé de l'invention, on applique un traitement thermique au substrat de type FD-SOI à une température supérieure ou égale à 1175°C, pendant un temps supérieur ou égal à 1h.

Pendant ledit traitement thermique, il se forme une jonction P-N, référencée 5, dans le substrat monocristallin 2 à une profondeur déterminée par rapport à la couche électriquement isolante 3, comme l'illustre la figure 2.

Plus précisément, le traitement thermique provoque les phénomènes suivants.

D'une part, des dopants de type P de la couche monocristalline diffusent dans le substrat monocristallin au travers de la couche électriquement isolante, dans une région du substrat voisine de la couche électriquement isolante.

D'autre part, lorsque le substrat monocristallin est dopé de type P, il se produit une inversion du type de dopage dans le substrat monocristallin 2.

La combinaison de ces deux phénomènes produit dans le substrat une région 6, dite première région, qui s'étend depuis la base du substrat monocristallin jusqu'à la jonction P-N et qui est dopée de type N du fait de l'inversion du type de dopage. La jonction P-N marque alors la frontière entre la première région 6, et la région restante 7 du substrat monocristallin, dite deuxième région, qui s'étend depuis la jonction P-N jusqu'à la couche électriquement isolante 3, et qui reste dopée de type P, la diffusion des dopants de type P dans cette deuxième région ayant compensé l'inversion du type de dopage.

Lorsque le substrat monocristallin est dopé N, le phénomène susmentionné de diffusion des dopants de type P dans la deuxième région se produit. En revanche, le phénomène d'inversion du type de dopage ne se produit pas. En conséquence, la première région reste dopée de type N.

Quel que soit le type de dopage initial du substrat monocristallin, à l'issue du traitement thermique, le substrat monocristallin comprend une jonction P-N séparant la première région (située du côté de la base du substrat) dopée de type N et la deuxième région (située du côté de la couche électriquement isolante) dopée de type P.

La formation de la jonction P-N est rendue possible par les trois caractéristiques suivantes :
- le dopage P de la couche monocristalline 4,
- la température du traitement thermique supérieure ou égale à 1175°C, pendant un temps supérieur ou égal à 1 heure,
- et, dans le cas d'un substrat monocristallin dopé de type P, la concentration élevée en oxygène interstitiel dudit substrat monocristallin 2.

La présence de la jonction P-N associée à la haute résistivité électrique du substrat cristallin 2, comprise entre 500 Ω.cm et 30 kΩ.cm, permet d'obtenir une structure présentant de très bonnes propriétés radiofréquences. Ces propriétés seront illustrées dans la suite du présent texte. L'ajustement de ces trois caractéristiques permet de contrôler la formation de la jonction P-N, et en particulier sa profondeur dans le substrat monocristallin 2 depuis la couche électriquement isolante 3.

Les paramètres du procédé, tels que par exemple les trois caractéristiques mentionnées précédemment, sont ajustés de manière à former la jonction P-N à une profondeur comprise entre 1 µm et 5 µm à partir de la couche électriquement isolante.

Dans le cas d'un substrat monocristallin de type P, le traitement thermique fait précipiter l'oxygène interstitiel présent dans le substrat monocristallin 2, ce qui forme des donneurs thermiques de type oxydes de soufre SₓO_{y} dotés de charges excédentaires venant doper le matériau du substrat monocristallin, et ainsi inverser le dopage de ce dernier. Ce premier phénomène est représenté schématiquement sur la figure 3, sur laquelle le dopage du matériau du substrat monocristallin par les donneurs thermiques est représenté par les flèches verticales ascendantes 8.

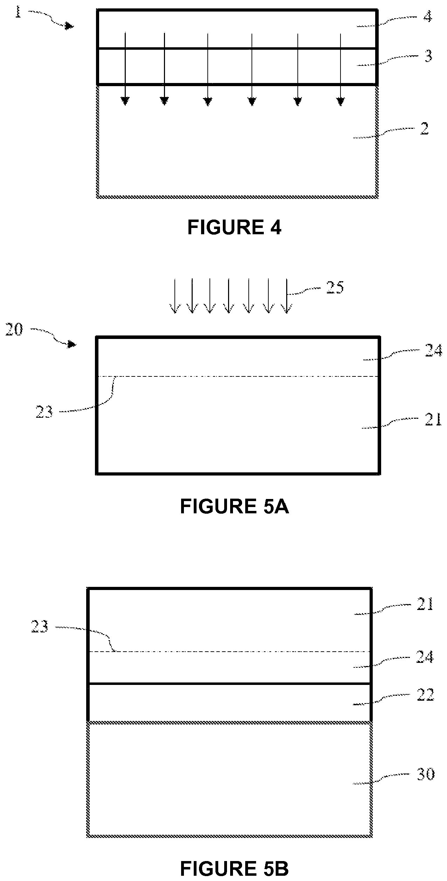

Par ailleurs, que le substrat monocristallin soit dopé de type N ou P, le traitement thermique provoque la diffusion des dopants de la couche monocristalline 4, tels que le bore, au travers de la couche électriquement isolante 3 qui est suffisamment fine, jusque dans le substrat monocristallin 2. Ces dopants peuvent également être utilisés pour contrôler la formation de la jonction P-N, et en particulier sa profondeur dans le substrat monocristallin depuis la couche électriquement isolante. Ce deuxième phénomène est représenté schématiquement sur la figure 4, sur laquelle la diffusion des dopants au travers de la couche électriquement isolante est représentée par les flèches verticales descendantes 9.

Ce deuxième phénomène, combiné au premier dans le cas d'un substrat monocristallin dopé de tpe P, conduisent à la formation de la première région du substrat de dopage N, et à la formation de la deuxième région dopée P, située entre la première région et la couche électriquement isolante, visibles sur la structure 10 de type semi-conducteur sur isolant de la figure 2.

Le procédé de l'invention offre l'avantage de permettre à ces deux phénomènes de se produire grâce aux trois caractéristiques listées précédemment, sans nécessité d'étapes de traitement supplémentaires. En particulier, contrairement à la jonction P-N latérale décrite dans l'article de M. Rack et al précité, la formation de la jonction P-N dans l'épaisseur du substrat dans la présente invention ne nécessite aucune implantation localisée de dopants ni aucun dépôt de masque sur le substrat.

Selon un mode de réalisation préféré, le substrat de type FD-SOI est obtenu par transfert d'une couche d'un substrat donneur sur un substrat receveur.

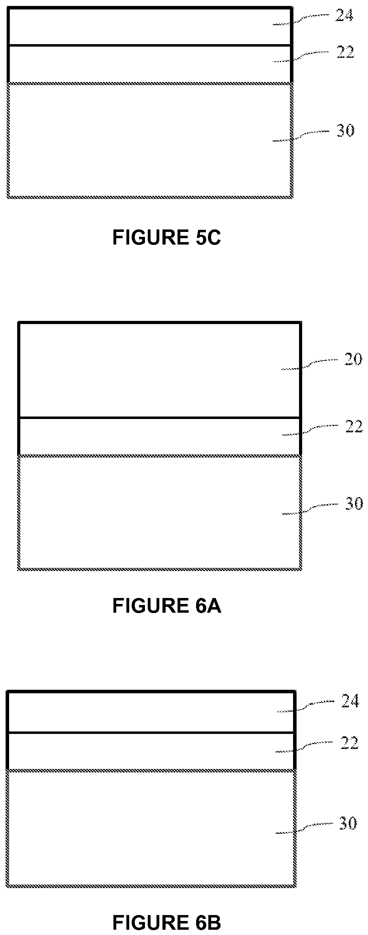

Selon une première alternative de ce mode de réalisation illustré sur les figures 5A, 5B, et 5C, on fournit un substrat donneur 20 comprenant une couche monocristalline 21, de préférence une couche de silicium, présentant un dopage de type P, et une zone de fragilisation 23 située dans la couche monocristalline délimitant la couche à transférer 24, telle qu'illustrée sur la figure 5A.

La couche monocristalline 24 à transférer est de préférence une couche de silicium.

On fournit également un substrat receveur monocristallin 30, de préférence en silicium, présentant une résistivité électrique comprise entre 500 Ω.cm et 30 kΩ.cm, une teneur en oxygène interstitiel (Oi) comprise entre 20 et 40 old ppma, et un dopage de type P ou N.

En référence à la figure 5B, on réalise alors le collage du substrat donneur 20 sur le substrat receveur 30 par l'intermédiaire d'une couche électriquement isolante 22 présentant une épaisseur comprise entre 20 nm et 400 nm. La couche électriquement isolante 22 se trouve alors entre le substrat donneur 20 et le substrat receveur 30.

La couche électriquement isolante 22 peut provenir du substrat donneur ou du substrat receveur, c'est-à-dire qu'elle peut se trouver initialement sur le substrat donneur ou sur le substrat receveur avant collage.

En référence à la figure 5C, on procède alors au détachement du substrat donneur 20 le long de la zone de fragilisation 23, pour obtenir le substrat de type FD-SOI.

De préférence, le transfert de la couche 24 du substrat donneur 20 vers le substrat receveur 30 est réalisée conformément au procédé Smart Cut^{™}, dans lequel la zone de fragilisation 23 est formée par implantation d'espèces atomiques, telles que par exemple des atomes d'hydrogène et/ou d'hélium, dans le substrat donneur, puis le substrat donneur est détaché le long de ladite zone de fragilisation.

Selon une deuxième alternative de ce mode de réalisation illustré sur les figures 6A et 6B, on fournit un substrat donneur 20 comprenant une couche semi-conductrice monocristalline 21, de préférence une couche de silicium, présentant un dopage de type P.

La couche monocristalline 21 est de préférence une couche de silicium.

On fournit également un substrat receveur monocristallin 30, de préférence en silicium, présentant une résistivité électrique comprise entre 500 Ω.cm et 30 kΩ.cm, une teneur en oxygène interstitiel (Oi) comprise entre 20 et 40 old ppma, et un dopage de type P ou N.

En référence à la figure 6A, on réalise alors le collage du substrat donneur 20 sur le substrat receveur 30 par l'intermédiaire d'une couche électriquement isolante 22 présentant une épaisseur comprise entre 20 nm et 400 nm. La couche électriquement isolante 22 se trouve alors entre le substrat donneur 20 et le substrat receveur 30.

La couche électriquement isolante 22 peut provenir du substrat donneur ou du substrat receveur, c'est-à-dire qu'elle peut se trouver initialement sur le substrat donneur ou sur le substrat receveur avant collage.

En référence à la figure 6B, on procède alors à un amincissement du substrat donneur 20 depuis la surface opposée au substrat receveur pour former la couche transférée 24, afin d'obtenir le substrat 1 de type FD-SOI.

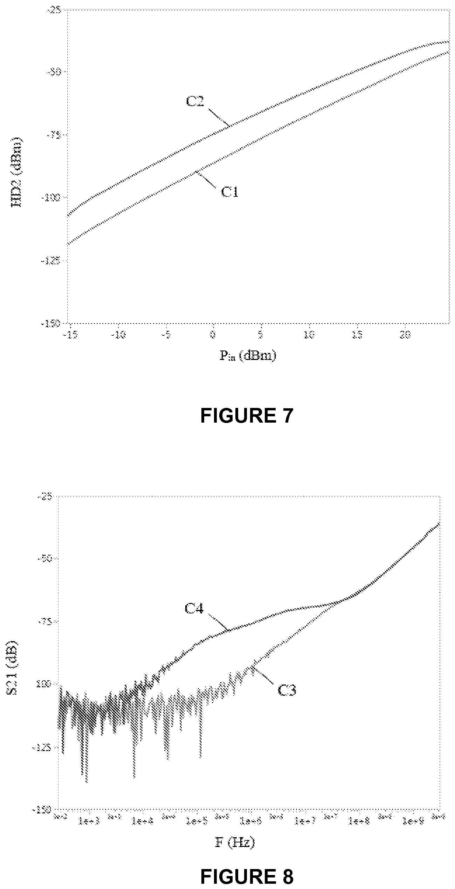

Les bonnes propriétés radiofréquences de la structure de type semi-conducteur sur isolant obtenue par le procédé décrit précédemment sont illustrées à l'aides des figures 7, 8, et 9.

La figure 7 est un graphe qui illustre le gain HD2 (dBm) pour une structure de type semi-conducteur sur isolant avec ou sans jonction P-N dans le substrat à haute résistivité électrique.

Le gain HD2 correspond au second harmonique, mesuré à une fréquence de 900 Mhz.

Plus précisément, HD2 est l'harmonique généré par le substrat pouvant parasiter le fonctionnement d'un dispositif radiofréquence comprenant la structure selon l'invention. Plus le HD2 est faible, plus le substrat est isolant. Le HD2 est mesuré à travers une ligne coplanaire avec un point d'entrée et un point de sortie. Au point d'entrée, on impose une puissance Pᵢₙ (dBm), et en sortie on mesure la puissance Pₒᵤₜ qui se décompose en plusieurs harmoniques dont en particulier HD1 qui correspond à la puissance mesurée en sortie approximativement égale à la puissance d'entrée, et HD2 qui correspond à l'harmonique généré par le substrat.

D'après le graphe de la figure 7, le gain HD2 obtenu pour la structure comprenant une jonction P-N (courbe C1) est inférieur à celui obtenu pour une structure sans jonction P-N (courbe C2). Ce décalage vers le bas de la courbe C2 par rapport à la courbe C1 correspond à une perte d'environ 10 dBm.

Dès lors, le substrat à haute résistivité de la structure à jonction P-N est plus isolant électriquement que celui de la structure sans jonction P-N.

La figure 8 est un graphe qui illustre le gain S21 (dB) pour une structure de type semi-conducteur sur isolant avec ou sans jonction P-N, en fonction de la fréquence (Hz).

Le gain S21 correspond à une mesure de diaphonie ou bruit (appelé « cross-talk » en anglo-saxon) qui traduit la capacité de composants par rapport à d'autres de communiquer à travers le substrat, représentant ainsi la performance d'isolation du substrat.

D'après le graphe de la figure 8, on observe une baisse du gain S21 obtenu pour la structure comprenant une jonction P-N (courbe C3) par rapport à celui obtenu pour une structure sans jonction P-N (courbe C4), entre 1e+3 Hz et 1e+8 Hz. Cette baisse de la courbe C4 par rapport à la courbe C3 correspond à un bruit réduit.

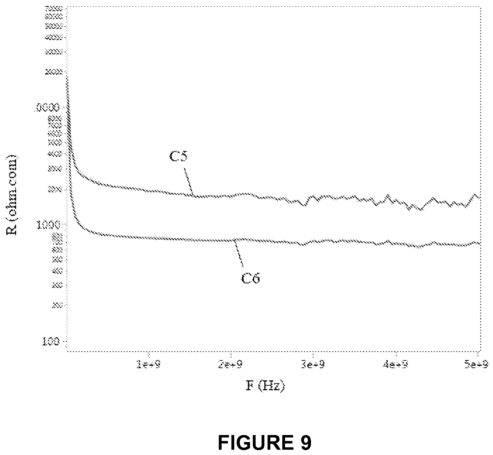

La figure 9 est un graphe qui illustre la résistivité R (ohm.cm) d'une structure de type semi-conducteur sur isolant avec ou sans jonction P-N dans le substrat à haute résistivité électrique, en fonction de la fréquence (Hz).

D'après le graphe de la figure 9, la résistivité obtenue pour la structure comprenant une jonction P-N (courbe C5) est supérieure à celle obtenue pour une structure sans jonction P-N (courbe C6). Ce décalage vers le bas de la courbe C5 par rapport à la courbe C6 correspond à une perte d'environ 1200 ohm.cm.

Ceci confirme le fait que le substrat à haute résistivité de la structure à jonction P-N est plus isolant électriquement que celui de la structure sans jonction P-N.

Les graphes des figures 7, 8, et 9 montrent ainsi que les performances radiofréquences de la structure de type semi-conducteur sur isolant de l'invention, comprenant une jonction P-N, sont fortement améliorées par rapport à celles d'une structure sans jonction P-N.

## Revendications

1. Procédé de fabrication d'une structure de type semi-conducteur sur isolant (10), comprenant les étapes suivantes :
- fourniture d'un substrat de type FD-SOI (1) comprenant successivement, depuis sa base vers son sommet :
• un substrat semi-conducteur monocristallin (2) présentant une résistivité électrique comprise entre 500 Ω.cm et 30 kΩ.cm, une teneur en oxygène interstitiel (Oi) comprise entre 20 et 40 old ppma, et présentant un dopage d'un premier type P ou N,
• une couche électriquement isolante (3) présentant une épaisseur comprise entre 20 nm et 400 nm, et
• une couche semi-conductrice monocristalline (4) présentant un dopage de type P,
- traitement thermique du substrat de type FD-SOI (1) à une température supérieure ou égale à 1175°C pendant un temps supérieur ou égal à 1h, afin de former une jonction P-N (5) dans le substrat semi-conducteur monocristallin (2) à une profondeur déterminée par rapport à la couche électriquement isolante (3),
• par la diffusion de dopants du type P depuis la couche semi-conductrice monocristalline (4) au travers de la couche électriquement isolante (3) dans ledit substrat (2),
• et, si le substrat (2) présente un dopage de type P, par la formation dans ledit substrat (2) de donneurs thermiques par précipitation de l'oxygène interstitiel,
pour former, dans le substrat, une première région (6) présentant un dopage de type N s'étendant entre la base du substrat et la jonction P-N et une deuxième région (7) dopée P située entre la première région (6) et la couche électriquement isolante (3).

2. Procédé de fabrication selon la revendication 1, dans lequel le substrat monocristallin (2) est en silicium et/ou la couche monocristalline (4) est une couche de silicium.

3. Procédé de fabrication selon la revendication 1 ou la revendication 2, dans lequel le substrat de type FD-SOI (1) est obtenu par transfert d'une couche (24) d'un substrat donneur (20) sur un substrat receveur (30), selon les étapes suivantes :
- fourniture
• du substrat donneur (20) comprenant une couche semi-conductrice monocristalline (21) présentant un dopage de type P, et une zone de fragilisation (23) située dans la couche de silicium monocristallin (21) délimitant la couche à transférer (24), et
• du substrat receveur semi-conducteur monocristallin (30), présentant une résistivité électrique comprise entre 500 Ω.cm et 30 kΩ.cm, une teneur en oxygène interstitiel (Oi) comprise entre 20 et 40 old ppma, et un dopage de d'un premier type P ou N,
- collage du substrat donneur (20) sur le substrat receveur (30) par l'intermédiaire d'une couche électriquement isolante (22) présentant une épaisseur comprise entre 20 nm et 400 nm,
- détachement du substrat donneur (20) le long de la zone de fragilisation (23), pour former le substrat de type FD-SOI (1).

4. Procédé de fabrication selon la revendication 1 ou la revendication 2, dans lequel le substrat de type FD-SOI (1) est obtenu par transfert d'une couche (24) d'un substrat donneur (20) sur un substrat receveur (30), selon les étapes suivantes :
- fourniture :
• du substrat donneur (20) comprenant une couche semi-conductrice monocristalline (21) présentant un dopage de type P, et
• du substrat receveur semi-conducteur monocristallin (30), présentant une résistivité électrique comprise entre 500 Ω.cm et 30 kΩ.cm, une teneur en oxygène interstitiel (Oi) comprise entre 20 et 40 old ppma, et un dopage de type P ou N,
- collage du substrat donneur (20) sur le substrat receveur (30) par l'intermédiaire d'une couche électriquement isolante (22) présentant une épaisseur comprise entre 20 et 400nm,
- amincissement du substrat donneur (20) depuis la surface opposée au substrat receveur (30) pour former la couche transférée (24), afin d'obtenir le substrat de type FD-SOI (1).

5. Procédé selon la revendication 3, dans lequel la zone de fragilisation (23) est formée par implantation d'espèces atomiques dans le substrat donneur (20), afin de délimiter la couche à transférer (24).

6. Procédé selon l'une quelconque des revendications 3 à 5, dans lequel le substrat receveur (30) et la couche monocristalline (21) du substrat donneur sont dopés P avec du bore.

7. Procédé selon l'une quelconque des revendications précédentes, dans lequel la jonction P-N (5) est formée à une profondeur comprise entre 1 µm et 5 µm à partir de la couche électriquement isolante (3).

8. Procédé selon l'une quelconque des revendications précédentes, dans lequel la couche électriquement isolante (3) comprend une couche d'oxyde de silicium.

## Patentansprüche

1. Verfahren zur Herstellung einer Struktur vom Typ Halbleiter auf Isolator (10), das die folgenden Schritte umfasst:
- Bereitstellen eines Substrats vom Typ FD-SOI (1), das nacheinander von seiner Basis bis zu seiner Spitze umfasst:
• ein monokristallines Halbleitersubstrat (2) mit einem elektrischen Widerstand zwischen 500 Ω.cm und 30 kΩ.cm, einem interstitiellen Sauerstoffgehalt (Oi) zwischen 20 und 40 old ppma und mit einer Dotierung eines ersten Typs P oder N,
• eine elektrisch isolierende Schicht (3) mit einer Dicke zwischen 20 nm und 400 nm, und
• eine monokristalline halbleitende Schicht (4) mit einer Dotierung vom Typ P,
- Wärmebehandlung des Substrats vom Typ FD-SOI (1) bei einer Temperatur über oder gleich 1175 °C während einer Zeit über oder gleich 1 h, um eine P-N-Verbindung (5) im monokristallinen Halbleitersubstrat (2) in einer bestimmten Tiefe in Bezug auf die elektrisch isolierende Schicht (3) zu bilden,
• durch Diffusion von Dotiermitteln des Typs P aus der monokristallinen halbleitenden Schicht (4) durch die elektrisch isolierende Schicht (3) in das Substrat (2),
• und, wenn das Substrat (2) eine Dotierung vom Typ P aufweist, durch Bildung thermischer Donoren in dem Substrat (2) durch Ausfällung des interstitiellen Sauerstoffs,
um in dem Substrat einen ersten Bereich (6) mit einer Dotierung vom Typ N zu bilden, der sich zwischen der Basis des Substrats und der P-N-Verbindung erstreckt, und einen zweiten P-dotierten Bereich (7), der sich zwischen dem ersten Bereich (6) und der elektrisch isolierenden Schicht (3) befindet.

2. Herstellungsverfahren nach Anspruch 1, wobei das monokristalline Substrat (2) aus Silizium besteht und/oder die monokristalline Schicht (4) eine Siliziumschicht ist.

3. Herstellungsverfahren nach Anspruch 1 oder Anspruch 2, wobei das Substrat vom Typ FD-SOI (1) durch Übertragung einer Schicht (24) eines Donorsubstrats (20) auf ein Aufnahmesubstrat (30) in folgenden Schritten erhalten wird:
- Bereitstellung
• des Donorsubstrats (20), das eine monokristalline halbleitende Schicht (21) mit einer Dotierung vom Typ P und eine Schwächungszone (23) umfasst, die sich in der monokristallinen Siliziumschicht (21) befindet, die die zu übertragende Schicht (24) begrenzt, und
• des monokristallinen halbleitenden Aufnahmesubstrats (30) mit einem elektrischen Widerstand zwischen 500 Ω.cm und 30 kΩ.cm, einem interstitiellen Sauerstoffgehalt (Oi) zwischen 20 und 40 old ppma und einer Dotierung eines ersten Typs P oder N,
- Kleben des Donorsubstrats (20) auf das Aufnahmesubstrat (30) über eine elektrisch isolierende Schicht (22), die eine Dicke zwischen 20 nm und 400 nm aufweist,
- Ablösen des Donorsubstrats (20) entlang der Schwächungszone (23), um das Substrat vom Typ FD-SOI (1) zu bilden.

4. Herstellungsverfahren nach Anspruch 1 oder Anspruch 2, wobei das Substrat vom Typ FD-SOI (1) durch Übertragung einer Schicht (24) eines Donorsubstrats (20) auf ein Aufnahmesubstrat (30) in folgenden Schritten erhalten wird:
- Bereitstellung:
• des Donorsubstrats (20), das eine monokristalline halbleitende Schicht (21) mit einer Dotierung vom Typ P umfasst, und
• des monokristallinen halbleitenden Aufnahmesubstrats (30) mit einem elektrischen Widerstand zwischen 500 Ω.cm und 30 kΩ.cm, einem interstitiellen Sauerstoffgehalt (Oi) zwischen 20 und 40 old ppma und einer Dotierung vom Typ P oder N,
- Kleben des Donorsubstrats (20) auf das Aufnahmesubstrat (30) über eine elektrisch isolierende Schicht (22), die eine Dicke zwischen 20 nm und 400 nm aufweist,
- Ausdünnen des Donorsubstrats (20) ab der dem Aufnahmesubstrat (30) gegenüberliegenden Oberfläche zur Bildung der übertragenen Schicht (24), um das Substrat vom Typ FD-SOI (1) zu erhalten.

5. Verfahren nach Anspruch 3, wobei die Schwächungszone (24) durch Implantation von Atomspezies in das Donorsubstrat (20) gebildet wird, um die zu übertragende Schicht (24) zu begrenzen.

6. Verfahren nach einem der Ansprüche 3 bis 5, wobei das Aufnahmesubstrat (30) und die monokristalline Schicht (21) des Donorsubstrats mit Bor P-dotiert sind.

7. Verfahren nach einem der vorhergehenden Ansprüche, wobei die P-N-Verbindung (5) in einer Tiefe zwischen 1 µm und 5 µm ab der elektrisch isolierenden Schicht (3) gebildet wird.

8. Verfahren nach einem der vorhergehenden Ansprüche, wobei die elektrisch isolierende Schicht (3) eine Siliziumoxidschicht umfasst.

## Claims

1. Process for manufacturing a semiconductor-on-insulator structure (10), comprising the following steps:
- provision of an FD-SOI substrate (1) comprising successively, from its base to its top:
• a single-crystal semiconductor substrate (2) with an electrical resistivity of between 500 Ω.cm and 30 kΩ.cm, an interstitial oxygen (Oi) content of between 20 and 40 old ppma, and doping of a first P or N type,
• an electrically insulating layer (3) with a thickness of between 20 nm and 400 nm, and
• a single-crystal semiconductor layer (4) with P-type doping,
- heat treatment of the FD-SOI substrate (1) at a temperature greater than or equal to 1175°C for a time greater than or equal to 1h, in order to form a P-N junction (5) in the single-crystal semiconductor substrate (2) at a determined depth with respect to the electrically insulating layer (3),
• by diffusion of P-type dopants from the single-crystal semiconductor layer (4) through the electrically insulating layer (3) in said substrate (2),
• and, if the substrate (2) has P-type doping, by the formation in said substrate (2) of thermal donors by precipitation of interstitial oxygen,
so as to form, in the substrate, a first region (6) with N-type doping extending between the base of the substrate and the P-N junction and a second P-doped region (7) located between the first region (6) and the electrically insulating layer (3).

2. Manufacturing process according to claim 1, wherein the single-crystal substrate (2) is made of silicon and/or the single-crystal layer (4) is a silicon layer.

3. Manufacturing process according to claim 1 or claim 2, wherein the FD-SOI substrate (1) is obtained by transferring a layer (24) of a donor substrate (20) onto a receiver substrate (30), according to the following steps:
- provision of
• the donor substrate (20) comprising a single-crystal semiconductor layer (21) with P-type doping, and an embrittlement zone (23) located in the single-crystal silicon layer (21) delimiting the layer to be transferred (24), and
• the single-crystal semiconductor receiver substrate (30), having an electrical resistivity of between 500 Ω.cm and 30 kΩ.cm, an interstitial oxygen (Oi) content of between 20 and 40 old ppma, and a doping of a first P or N type,
- bonding of the donor substrate (20) to the receiver substrate (30) via an electrically insulating layer (22) with a thickness of between 20 nm and 400 nm,
- detachment of the donor substrate (20) along the embrittlement zone (23), to form the FD-SOI substrate (1).

4. Manufacturing process according to claim 1 or claim 2, wherein the FD-SOI substrate (1) is obtained by transferring a layer (24) of a donor substrate (20) onto a receiver substrate (30), according to the following steps:
- provision of:
• a donor substrate (20) comprising a single-crystal semiconductor layer (21) with P-type doping, and
• the single-crystal semiconductor receiver substrate (30), with an electrical resistivity of between 500 Ω.cm and 30 kΩ.cm, an interstitial oxygen (Oi) content of between 20 and 40 old ppma, and P- or N-type doping,
- bonding of the donor substrate (20) to the receiver substrate (30) via an electrically insulating layer (22) with a thickness of between 20 and 400 nm,
- thinning of the donor substrate (20) from the surface opposite the receiver substrate (30) to form the transferred layer (24), to obtain the FD-SOI substrate (1).

5. Process according to claim 3, wherein the embrittlement zone (24) is formed by implanting atomic species into the donor substrate (20), in order to delimit the layer to be transferred (24).

6. Process according to any one of claims 3 to 5, wherein the receiver substrate (30) and the single-crystal layer (21) of the donor substrate are P-doped with boron.

7. A process according to any of the preceding claims, wherein the P-N junction (5) is formed at a depth of between 1 µm and 5 µm from the electrically insulating layer (3).

8. A process according to any of the preceding claims, wherein the electrically insulating layer (3) comprises a silicon oxide layer.
